(19) Europäisches Patentamt
European Patent Office
Office européen des brevets

(11) **EP 3 664 588 B1**

(12) **FASCICULE DE BREVET EUROPEEN**

(45) Date de publication et mention de la délivrance du brevet:
**11.01.2023 Bulletin 2023/02**

(21) Numéro de dépôt: **19207752.7**

(22) Date de dépôt: **07.11.2019**

(51) Classification Internationale des Brevets (IPC):
**H05K 7/20** *(2006.01)* **H02B 1/56** *(2006.01)*

(52) Classification Coopérative des Brevets (CPC):
**H05K 7/20618;** H02B 1/565

(54) **SYSTEME DE GESTION DE LA TEMPERATURE DANS UNE ENVELOPPE ELECTRIQUE**

SYSTEM ZUR TEMPERATURSTEUERUNG IN EINER ELEKTRISCHEN HÜLLE

SYSTEM FOR MANAGING THE TEMPERATURE IN AN ELECTRIC ENVELOPE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.12.2018 FR 1872311**

(43) Date de publication de la demande:
**10.06.2020 Bulletin 2020/24**

(73) Titulaire: **Schneider Electric Industries SAS 92500 Rueil Malmaison (FR)**

(72) Inventeurs:
  • **AGNAOU, Abderrahmane 38050 Grenoble Cedex 09 (FR)**
  • **LOPEZ, Josep 38050 Grenoble Cedex 09 (FR)**
  • **PERRIN, Alain 38050 Grenoble Cedex 09 (FR)**

(74) Mandataire: **Schneider Electric Service Propriété Industrielle 160 Avenue des Martyrs 38000 Grenoble (FR)**

(56) Documents cités:
**EP-A1- 2 789 220 EP-A1- 3 093 936**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**Domaine technique de l'invention**

La présente invention se rapporte à un système de gestion de la température dans une enveloppe électrique.
L'invention concerne également un procédé de gestion de la température mis en œuvre à l'aide dudit système.

**Etat de la technique**

La gestion de la température dans l'enceinte d'une enveloppe électrique, telle qu'une armoire électrique ou un coffret, est une question traitée de manière récurrente. Les appareils présents dans l'enveloppe ont tendance à chauffer et il est donc nécessaire de maintenir la température à l'intérieur de l'enveloppe sous un certain seuil, au risque sinon de dégrader les appareils. A l'inverse, il est également possible de devoir chauffer l'espace interne de l'enveloppe lorsque l'enceinte subit des variations de températures susceptibles de créer de la condensation. C'est notamment le cas lorsque l'enveloppe est placée à l'extérieur car il peut ainsi faire très chaud pendant la journée et très froid pendant la nuit.
Pour répondre à ces différentes contraintes, il est classique d'utiliser un système de ventilation pour permettre une circulation d'air dans l'enveloppe. Une solution de climatisation et/ou de chauffage peut être utilisée respectivement en remplacement ou en complément afin de réguler la température à l'intérieur de l'enveloppe.
Cependant, ces solutions ne s'avèrent pas toujours économes en énergie.
Il existe toujours un besoin de proposer une solution de gestion de la température dans une enveloppe électrique, telle qu'une armoire électrique, qui puisse fonctionner pour produire du froid ou du chaud, qui puisse tenir compte des variations de température, parfois importantes, subies par l'enveloppe électrique, qui soit fiable, économe en énergie électrique et qui ne nécessite pas l'emploi de composants spécifiques.
On connaît les documents EP 2 789 220 et EP 3 093 936 décrivant un système de gestion de la température, adaptable sur une enveloppe électrique, ladite enveloppe électrique délimitant un premier volume fermé par rapport à l'extérieur.

**Exposé de l'invention**

Ce but est atteint par un système de gestion de la température selon la revendication 1.
Selon une particularité, le système comporte un troisième mode de fonctionnement dans lequel l'unité de commande et de traitement commande les premiers moyens de transfert d'air et les deuxièmes moyens de transfert d'air pour bloquer tout flux d'air respectivement entre le premier volume et le deuxième volume et entre le premier volume et le troisième volume.
Selon une autre particularité, le système comporte des moyens de détermination d'une première période d'activation des premiers moyens de transfert d'air et des deuxièmes moyens de transfert d'air et d'une deuxième période d'activation des premiers moyens de transfert d'air et des deuxièmes moyens de transfert d'air.
Selon une autre particularité, la première période d'activation est définie par un premier intervalle de temps dénommé Dtc et défini par la relation suivante :

$$Dtc = tc_{max} - tc_{min}$$

Dans laquelle :

- $tc_{min}$ correspond à un premier instant correspondant à la température ($T_{max} - e_c$),
- $tc_{max}$ correspond à un deuxième instant correspondant à la température ($T_{max} - ec$),
- Tmax correspond à une valeur maximale de température subie par le système sur une période donnée et $e_c$ correspond à un premier écart de température.

Selon une autre particularité, la deuxième période d'activation est définie par un deuxième intervalle de temps dénommé Dtf et défini par la relation suivante :

$$Dtf = tf_{max} - tf_{min}$$

Dans laquelle :

- tf$_{min}$ correspond à un premier instant correspondant à une température (T$_{min}$ + e$_f$),
- tf$_{max}$ correspond à un deuxième instant correspondant à la température (T$_{min}$ + e$_f$),
- Tmin correspond à une valeur minimale de température subie par le système sur ladite période donnée et et correspond à un deuxième écart de température.

Selon une autre particularité, le système comporte un capteur de température configurée pour fournir la valeur minimale de température et la valeur maximale de température.

Selon une autre particularité, le système comporte des moyens de connexion à un serveur de données météorologiques et des moyens d'interrogation dudit serveur pour obtenir ladite valeur minimale de température et ladite valeur maximale de température et une courbe d'évolution de la température.

Selon une autre particularité, le système comporte un capteur de température destiné à être placé dans le premier volume et en ce que l'unité de commande et de traitement comporte une entrée reliée audit capteur de température et en ce que lesdits moyens de détermination du mode de fonctionnement sont configurés pour se baser sur des données de mesure de température fournies par ledit capteur.

Selon une autre particularité, lesdits moyens de détermination du mode de fonctionnement comportent des moyens de comparaison de chaque donnée de température fournie par ledit capteur de température avec au moins une valeur seuil. Selon une autre particularité, lesdits moyens de détermination du mode de fonctionnement comportent des moyens de calcul de la température de rosée et en ce qu'il comporte des moyens de comparaison de chaque donnée de température fournie par ledit capteur de température avec ladite température de rosée.

Selon une autre particularité, les premiers moyens de transfert d'air comportent un premier ventilateur commandé par l'unité de commande et de traitement.

Selon une autre particularité, les premiers moyens de transfert d'air comportent des moyens d'obturation de la première entrée/sortie d'air et/ou de la deuxième entrée/sortie d'air, commandés par l'unité de commande et de traitement.

Selon une autre particularité, les deuxièmes moyens de transfert d'air comportent un deuxième ventilateur commandé par l'unité de commande et de traitement.

Selon une autre particularité, les deuxièmes moyens de transfert d'air comportent des moyens d'obturation de la troisième entrée/sortie d'air et/ou de la quatrième entrée/sortie d'air, commandés par l'unité de commande et de traitement.

Selon une autre particularité, les premiers moyens de transfert d'air et les deuxièmes moyens de transfert d'air comportent une platine rotative autour d'un axe, ladite platine portant un unique ventilateur et une ouverture diamétralement opposés et étant commandé par l'unité de commande et de traitement pour tourner autour de son axe entre au moins deux positions, une première position angulaire dans laquelle son ventilateur est positionné entre la première entrée/sortie d'air et la deuxième entrée sortie d'air et son ouverture est positionnée entre la troisième entrée/sortie d'air et la quatrième entrée sortie d'air et une deuxième position angulaire dans laquelle son ventilateur est positionné entre la troisième entrée/sortie d'air et la quatrième entrée/sortie d'air et son ouverture est positionnée entre la première entrée/sortie d'air et la deuxième entrée/sortie d'air.

Selon une autre particularité, la première position angulaire et la deuxième position angulaire sont obtenues par une rotation de la platine de 180°.

Selon une autre particularité, la platine est configurée pour prendre au moins une troisième position angulaire décalée de 90° par rapport à la première position angulaire, ladite troisième position angulaire correspondant à un mode de fonctionnement dans lequel la platine s'interpose entre la première entrée/sortie d'air et la deuxième entrée/sortie d'air pour bloquer leur liaison et la platine s'interpose entre la troisième entrée/sortie d'air et la quatrième entrée/sortie d'air pour bloquer leur liaison.

Selon une autre particularité, le réservoir est réalisé dans un matériau extensible.

L'invention concerne également une installation électrique comportant une enveloppe électrique qui comprend une paroi inférieure, une paroi supérieure et au moins une paroi latérale, de manière à délimiter un premier volume fermé, ladite installation comportant un système tel que défini ci-dessus qui est installé sur l'une de ses parois, la deuxième entrée/sortie d'air et la quatrième entrée/sortie d'air du système étant connectés audit premier volume.

L'invention concerne également un procédé de gestion de la température dans une installation électrique telle que définie ci-dessus, le procédé comportant les étapes suivantes :

- Sélection d'un mode de fonctionnement du système,
- Application dudit mode de fonctionnement sélectionné par commande des premiers moyens de transfert d'air et des deuxièmes moyens de transfert d'air.

## Brève description des figures

D'autres caractéristiques et avantages vont apparaître dans la description détaillée qui suit faite en regard des dessins annexés dans lesquels :

- La figure 1 représente le système de gestion de la température conforme à l'invention adapté sur une armoire électrique ;
- La figure 2 représente les moyens de transfert d'air employés dans le système de l'invention ;
- La figure 3 illustre de manière schématique les échanges d'air réalisés respectivement dans le premier mode de fonctionnement et dans le deuxième mode de fonctionnement ;
- Les figures 4A, 4B, 5A, 5B, 6A, 6B illustrent les différents états de fonctionnement du système de l'invention ;
- Les figures 7A à 7E représentent un exemple de réalisation d'une partie du système de l'invention et illustrent son principe de fonctionnement ;
- La figure 8 représente par une courbe un principe de contrôle par la température du système de l'invention ;

## Description détaillée d'au moins un mode de réalisation

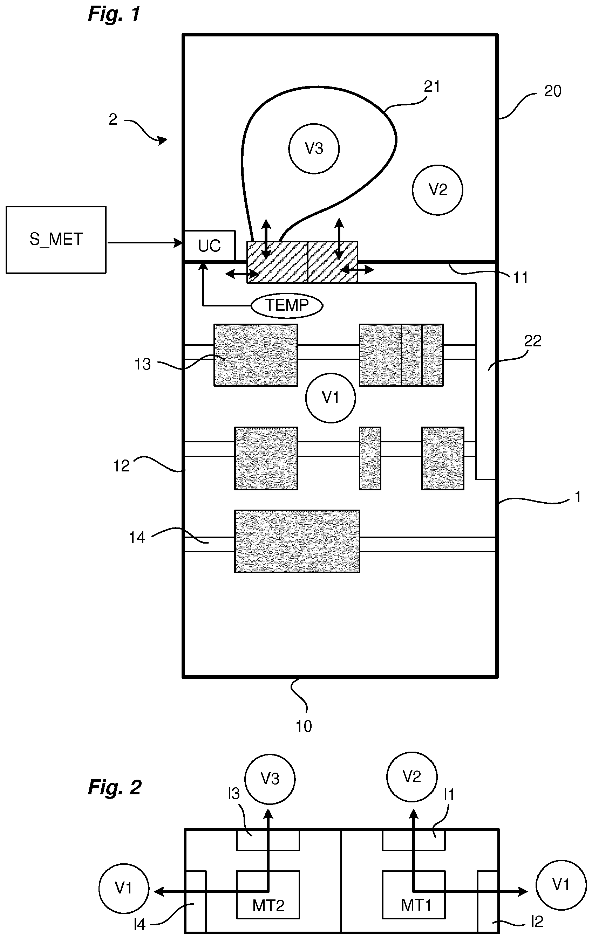

En référence à la figure 1, le système de gestion de la température de l'invention est adaptable sur une enveloppe électrique. Par enveloppe électrique, on entend une armoire électrique, un coffret électrique ou équivalent. Dans la suite de la description et sur les dessins, on considérera que l'enveloppe électrique est une armoire électrique 1.

De manière non limitative, une armoire électrique 1 peut comporter une paroi inférieure 10, une paroi supérieure 11 et quatre parois latérales 12 opposées deux à deux. Ses parois délimitent un premier volume interne fermé V1 dans lequel sont placés des appareils électriques. Dans l'armoire électrique, les appareils électriques 13 peuvent être montés sur des supports, tels que montants et rails 14 adaptés. L'armoire 1 peut comporter une grille permettant à son volume interne d'échanger de l'air avec l'extérieur ou être complètement hermétique, notamment lorsqu'elle est destinée à être employée en extérieur. L'armoire 1 pourra être fabriqué dans un matériau métallique.

De manière non limitative, le système 2 de gestion de la température conforme à l'invention peut être fixé sur la paroi supérieure 11 de l'armoire électrique.

De manière générale, le système 2 de gestion de la température de l'invention présente la particularité de pouvoir stocker de l'air chaud lors des périodes chaudes pour le restituer lors des périodes plus froides et de pouvoir stocker de l'air froid lors des périodes froides pour le restituer lors des périodes plus chaudes.

Pour cela, le système 2 conforme à l'invention comporte une première enceinte 20 délimitant un deuxième volume V2 fermé, distinct du volume V1 de l'armoire. Il pourra s'agir d'un caisson hermétique. Cette enceinte 20 est avantageusement réalisée dans un matériau le plus isolant possible de la chaleur de manière à limiter au maximum les échanges thermiques entre l'espace interne de cette enceinte et l'extérieur.

Le système 2 comporte également un réservoir 21 délimitant un troisième volume fermé, distinct du premier volume V1 et du deuxième volume V2. Le réservoir 21 est également réalisé dans un matériau garantissant une séparation hermétique du troisième volume V3 par rapport au deuxième volume V2.

Le réservoir 21 est destiné à être placé dans le deuxième volume V2 de la première enceinte 20.

Le réservoir 21 est réalisé dans un matériau souple, lui permettant de faire varier son volume d'une valeur minimale pouvant être égale à zéro à une valeur maximale correspondant à celui du deuxième volume V2 délimité par l'enceinte 20. La paroi de cette enceinte 21 est avantageusement réalisée dans un matériau le plus isolant possible de la chaleur de manière à limiter au maximum les échanges thermiques avec l'espace V2.

On verra ci-après que le réservoir 21 peut également être réalisé dans un matériau extensible, type ballon de baudruche, lui permettant de se dégonfler et de libérer l'air qu'il aura préalablement stocké sous la seule pression de ses parois.

Le système 2 comporte une première entrée/sortie d'air I1 connectée au deuxième volume V2 et une deuxième entrée/sortie d'air I2 destinée à être connectée au premier volume V1 lorsque le système 2 est adapté sur l'armoire électrique 1.

Le système 2 comporte une troisième entrée/sortie d'air I3 connectée au troisième volume V3 et une quatrième entrée/sortie d'air I4 destinée à être connectée au premier volume V1 lorsque le système 2 est adapté sur l'armoire électrique 2.

Toutes les entrées/sorties d'air sont indépendantes et distinctes, c'est-à-dire qu'elles ne communiquent pas entre elles.

Chaque entrée/sortie d'air peut être réalisée sous la forme d'un canal débouchant dans le volume fermé considéré.

La deuxième entrée/sortie d'air I2 et la quatrième entrée/sortie d'air I4 du système sont destinées à venir se connecter sur des ouvertures correspondantes réalisées sur une paroi de l'armoire électrique 1, par exemple la paroi supérieure 11 de celle-ci.

Le système 2 peut comporter une goulotte 22 connectée à la quatrième entrée/sortie d'air I4, ladite goulotte 22 débouchant à l'intérieur du volume V1 de l'armoire électrique, préférentiellement de manière centrale par rapport au volume V1 de l'armoire afin de mieux diffuser/prélever l'air.

Le système 2 comporte également des premiers moyens de transfert d'air MT1 agencés entre la première entrée/sortie d'air I1 et la deuxième entrée/sortie d'air I2 et des deuxièmes moyens de transfert d'air MT2 agencés entre la troisième entrée/sortie d'air I3 et la quatrième entrée/sortie d'air I4.

Les premiers moyens de transfert d'air MT1 peuvent comporter au moins un ventilateur et être commandés pour permettre un transfert d'air de la première entrée/sortie d'air I1 vers la deuxième entrée/sortie d'air I2, donc du deuxième volume V2 vers le premier volume V1 lorsque le système est adapté sur l'armoire électrique 1, ou de la deuxième entrée/sortie d'air I2 vers la première entrée/sortie d'air I1, donc du premier volume V1 vers le deuxième volume V2 lorsque le système 2 est adapté sur l'armoire électrique 1.

Les deuxièmes moyens de transfert d'air MT2 peuvent comporter au moins un ventilateur et être commandés pour permettre un transfert d'air de la troisième entrée/sortie d'air I3 vers la quatrième entrée/sortie d'air I4, donc du troisième volume V3 vers le premier volume V1 lorsque le système 2 est adapté sur l'armoire électrique 1, ou de la quatrième entrée/sortie d'air I4 vers la troisième entrée/sortie d'air I3, donc du premier volume V1 vers le troisième volume V3 lorsque le système 2 est adapté sur l'armoire électrique 1.

Les premiers moyens de transfert d'air MT1 peuvent comporter un premier ventilateur VENT1 agencé entre les deux sorties d'air.

Les deuxièmes moyens de transfert d'air MT2 peuvent comporter un deuxième ventilateur VENT2 agencé entre les deux sorties d'air.

On verra ci-après que, dans un mode de réalisation particulier de l'invention, un seul ventilateur peut être employé.

Selon un aspect particulier de l'invention, on distingue plusieurs modes de fonctionnement possibles du système 2 :

- Premier mode de fonctionnement MOD1 : Premier transfert d'air du premier volume V1 vers le troisième volume V3 et deuxième transfert d'air simultané du deuxième volume V2 vers le premier volume V1 ;

- Deuxième mode de fonctionnement MOD2 : Premier transfert d'air du premier volume V1 vers le deuxième volume V2 et deuxième transfert d'air simultané du troisième volume V3 vers le premier volume V1.

- Troisième mode de fonctionnement MOD3 : Système fermé, c'est-à-dire aucun transfert d'air d'un volume à un autre.

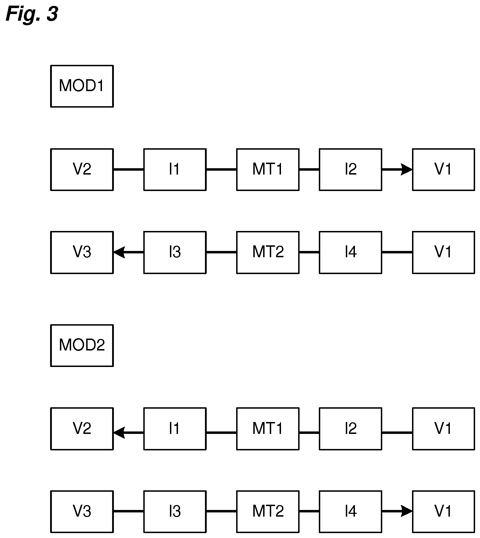

La figure 3 illustre les échanges d'air réalisés entre les différents volumes dans chacun des deux premiers modes de fonctionnement.

Le système 2 comporte une unité de commande et de traitement UC destinée à commander chaque mode de fonctionnement du système. Cette unité de commande et de traitement UC peut notamment comporter des modules d'entrées/sorties. Les premiers moyens de transfert d'air MT1 peuvent être connectés sur un premier module de sortie de l'unité de commande et de traitement UC et les deuxièmes moyens de transfert d'air MT2 peuvent être connectés sur un deuxième module de sortie de l'unité de commande et de traitement UC. On verra que l'unité de commande et de traitement UC peut comporter des moyens de calculs lui permettant de déterminer dans quelle mode de fonctionnement le système 2 doit fonctionner.

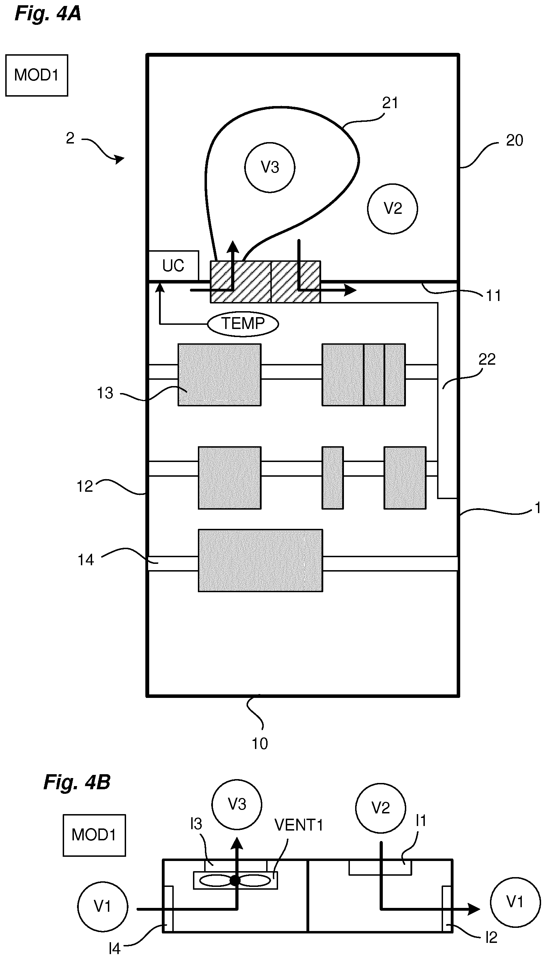

En référence aux figures 4A et 4B, dans le premier mode de fonctionnement MOD1, les deuxièmes moyens de transfert d'air MT2, c'est-à-dire le deuxième ventilateur VENT2, sont commandés par l'unité de commande et de traitement UC pour aspirer l'air présent dans le premier volume V1 et le transférer vers le troisième volume V3. Dans le même temps, l'expansion du réservoir 21 à l'intérieur de l'enceinte 20 pousse l'air présent dans le volume V2 vers le volume V1, à travers la première entrée/sortie d'air I1 et la deuxième entrée/sortie d'air I2. Si un ventilateur est présent entre ces dernières deux entrées/sorties, celui-ci peut aider au transfert d'air du volume V2 vers le volume V1 mais ce ventilateur reste optionnel. L'air peut être injecté du volume V2 vers le volume V1 via ladite goulotte 22.

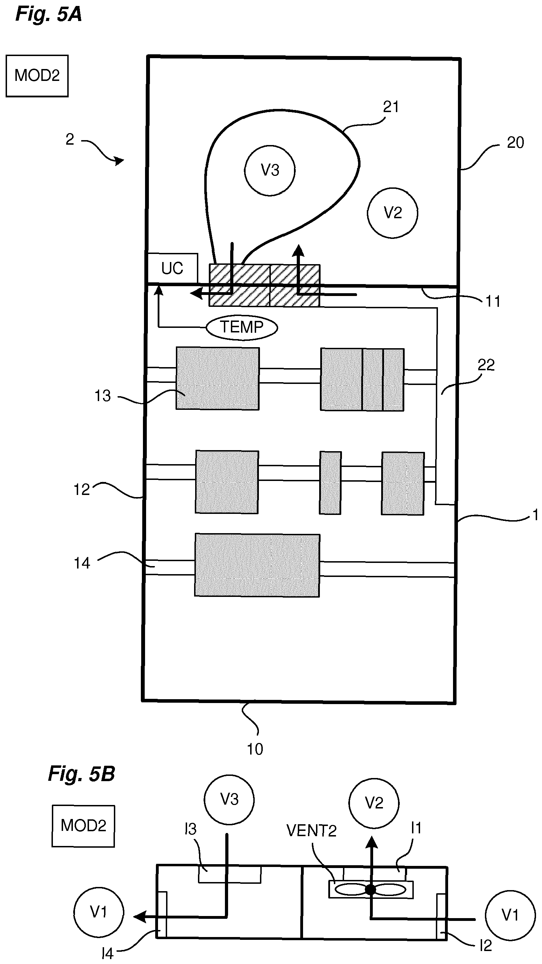

En référence aux figures 5A et 5B, dans le deuxième mode de fonctionnement MOD2, les premiers moyens de transfert d'air MT1, c'est-à-dire le premier ventilateur VENT1, sont commandés par l'unité de commande et de traitement UC pour aspirer l'air présent dans le premier volume V1 et le transférer dans le deuxième volume V2. Dans le même temps, l'air injecté dans le deuxième volume V2 comprime le réservoir, forçant l'air présent dans le troisième volume V3 à s'échapper vers le premier volume V1, à travers la troisième entrée/sortie d'air I3 et la quatrième entrée/sortie d'air I4. Si un ventilateur est présent entre ces deux dernières entrées/sorties, celui-ci peut aider au transfert d'air du volume V3 vers le volume V1 mais ce ventilateur reste optionnel.

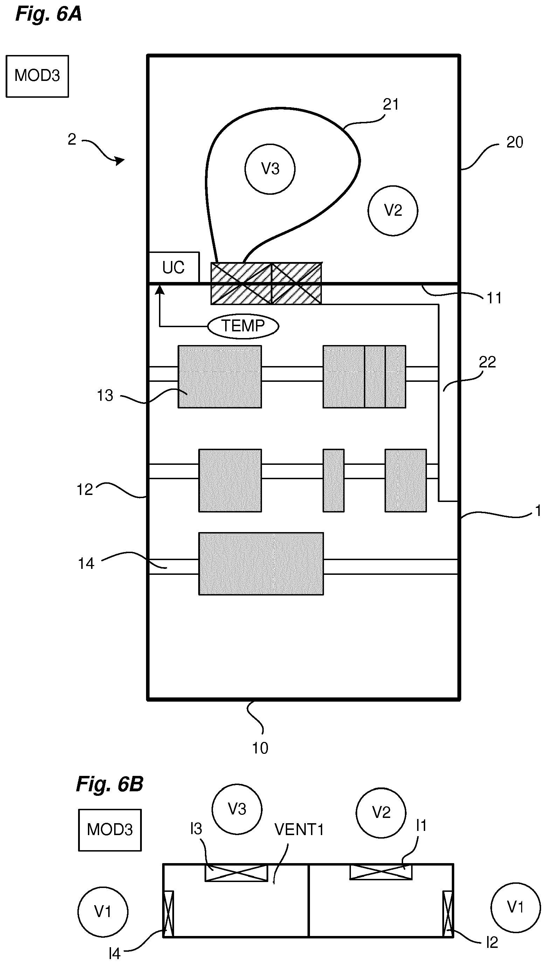

Sur les figures 6A et 6B, les transferts d'air d'un volume à un autre sont interrompus. Il s'agit donc du troisième mode de fonctionnement MOD3, dans lequel les entrées/sorties d'air du système sont obturées.

De manière non limitative mais particulièrement avantageuse, le système 2 peut ne fonctionner qu'avec un seul ventilateur pour les deux modes de fonctionnement MOD1, MOD2 décrits ci-dessus. Ce seul et même ventilateur VENT est en effet employé alternativement comme premiers moyens de transfert d'air MT1 ou comme deuxièmes moyens de transfert d'air MT2, selon le mode de fonctionnement du système. Ainsi, ce seul ventilateur VENT est employé dans le premier mode de fonctionnement MOD1 pour le premier transfert d'air du volume V1 vers le volume V3 et une simple et unique ouverture O est alors employée pour réaliser le deuxième transfert d'air du volume V2 vers le volume V1. Et dans le deuxième mode de fonctionnement, ce seul ventilateur VENT est employé pour le premier transfert d'air du volume V1 vers le volume V2 alors que ladite ouverture O est employée pour le deuxième transfert d'air du volume V3 vers le volume V1.

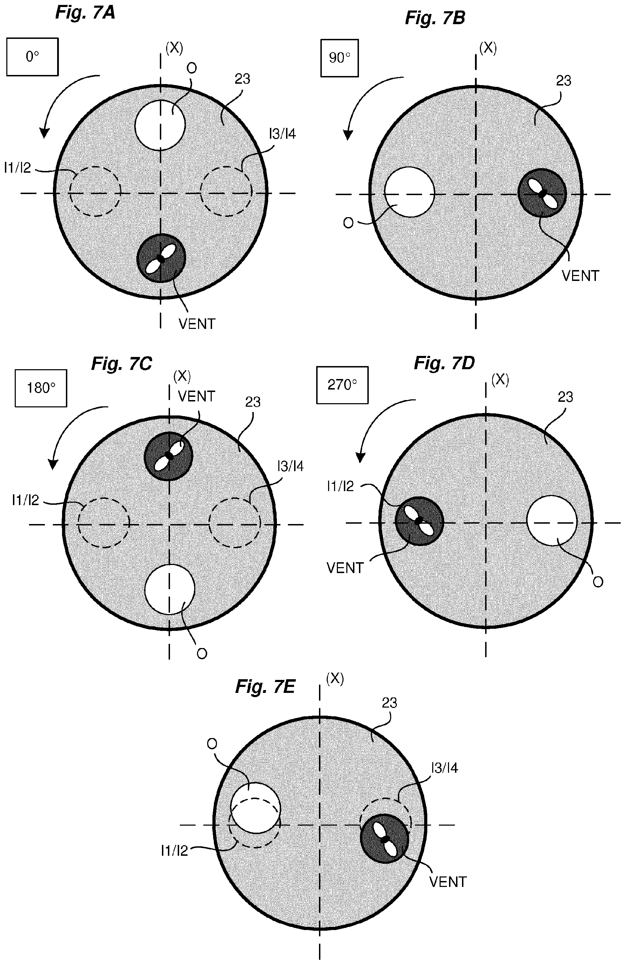

Dans cette réalisation à un seul ventilateur VENT, en référence aux figures 7A à 7E, le système 2 peut comporter une platine 23 montée en rotation sur elle-même autour d'un axe. La platine 23 comporte l'ouverture O et porte le ventilateur VENT qui est fixé sur la platine 23 dans une position diamétralement opposée par rapport à celle de ladite ouverture O. En faisant tourner la platine 23 autour de son axe entre plusieurs positions angulaires fixes distinctes, il est ainsi possible de positionner le ventilateur VENT et l'ouverture O dans la position nécessaire au mode de fonctionnement à appliquer.

Sur la figure 7A, la platine 23 est dans une première position angulaire dite à 0° par rapport à un axe vertical (X) perpendiculaire à son axe de rotation et situé dans le plan de la platine 23, cette position étant la position de référence de la platine 23. Dans cette première position, la platine 23 vient s'interposer entre la première entrée/sortie d'air I1 et la deuxième entrée/sortie d'air I2 et entre la troisième entrée/sortie d'air I3 et la quatrième entrée/sortie d'air I4, empêchant tout flux d'air de passer d'un volume à l'autre. Le système est donc dans le troisième mode de fonctionnement MOD3, c'est-à-dire en mode fermé.

Sur la figure 7B, la platine 23 est dans une deuxième position angulaire dite à 90° (rotation dans le sens trigonométrique) par rapport audit axe vertical (X). Dans cette deuxième position, le ventilateur VENT est placé entre la troisième entrée/sortie d'air I3 et la quatrième entrée/sortie d'air I4 et l'ouverture O qui est diamétralement opposée est donc placée entre la première entrée/sortie d'air I1 et la deuxième entrée/sortie d'air I2. Le système 2 est donc prêt à fonctionner selon le premier mode de fonctionnement MOD1.

Sur la figure 7C, la platine 23 est dans une troisième position angulaire dite à 180° par rapport audit axe vertical (X). Dans cette troisième position, la platine 23 vient s'interposer entre la première entrée/sortie d'air I1 et la deuxième entrée/sortie d'air I2 et entre la troisième entrée/sortie d'air I3 et la quatrième entrée/sortie d'air I4, empêchant tout flux d'air de passer d'un volume à l'autre. Le système est donc dans le troisième mode de fonctionnement MOD3, c'est-à-dire en mode fermé.

Sur la figure 7D, la platine 23 est dans une troisième position angulaire dite à 270° par rapport audit axe vertical (X). Dans cette troisième position, le ventilateur VENT se trouve en vis-à-vis de la première entrée/sortie d'air I1 et de la deuxième entrée/sortie d'air I2 et l'ouverture O se trouve en vis-à-vis de la troisième entrée/sortie d'air I3 et de la quatrième entrée/sortie d'air I4. Le système est donc prêt à fonctionner selon le deuxième mode de fonctionnement MOD2.

La platine 23 peut être fixée sur l'axe d'un moteur électrique connecté sur un module de sortie de l'unité de commande et de traitement UC. Selon le mode de fonctionnement à appliquer, l'unité de commande et de traitement UC commande le moteur électrique pour faire tourner la platine et lui faire prendre la position angulaire désirée.

Selon un aspect particulier de l'invention, pour réguler le débit d'air vers chaque volume, il est possible de contrôler la position de l'ouverture O réalisée sur la platine. En faisant varier la position angulaire de la platine 23 par commande du moteur, l'unité de commande et de traitement UC peut contrôler la position de l'ouverture vis-à-vis des deux entrées/sorties d'air et ainsi augmenter ou réduire le débit d'air de manière simple. Le contrôle du débit d'air peut être réalisé par l'unité de commande et de traitement en tenant compte de différents paramètres (mode de fonctionnement appliqué, température(s), défaut de fonctionnement,...). La figure 7E montre ainsi une position intermédiaire de la platine dans laquelle l'ouverture O est partiellement en vis-à-vis de deux entrées/sorties d'air.

Selon un aspect particulier de l'invention, dans le premier mode de fonctionnement, le premier transfert d'air du volume V1 vers le volume V3 est un transfert d'air dit chaud, tandis que le deuxième transfert d'air du volume V2 vers le volume V1 est un transfert d'air dit froid.

Dans le deuxième mode de fonctionnement, le premier transfert d'air du volume V1 vers le volume V2 est un transfert d'air dit froid, tandis que le deuxième transfert d'air du volume V3 vers le volume V1 est un transfert d'air dit chaud.

Chaque mode de fonctionnement peut être commandé selon différentes variantes de réalisations exposées ci-dessous.

Dans une première variante de réalisation, il s'agit de définir plusieurs périodes de temps de fonctionnement du système. Au moins une première période correspond à un intervalle de temps dit chaud alors que au moins une deuxième période correspond à un intervalle de temps dit froid.

Pour définir chacune des deux périodes, les moyens de calcul de l'unité de commande et de traitement considèrent une période T (par exemple égale à une journée) et détermine, sur cette période T, la variation de la température à laquelle l'armoire électrique est exposée. La courbe de variation de température peut être générée en tenant compte des données de prévision météorologiques du lieu dans lequel l'armoire électrique est implantée ou à partir de données météorologiques obtenues pour la même période, une année précédente, ou après une période d'apprentissage, ou par tout autre moyen. L'unité de commande et de traitement peut notamment disposer d'un accès à un serveur de données météorologiques (S_MET-figure 1) lui permettant de disposer des données nécessaires à la création de la courbe.

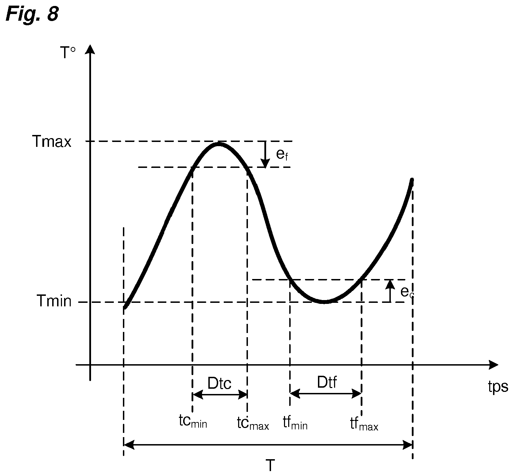

Un exemple de courbe de variation de la température sur cette période T est représenté sur la figure 8.

Sur la période T et à partir de la courbe, on peut voir que la température augmente jusqu'à atteindre une valeur maximale Tmax pour ensuite diminuer jusqu'à atteindre une valeur minimale Tmin. L'amplitude de température sur cette période est donc de Tmax - Tmin.

Pour définir les intervalles de temps froids et chauds, les moyens de calcul procèdent de la manière ci-dessous.

On définit :

Dtf : intervalle de temps froid = $tf_{max}$ - $tf_{min}$

Dtc : intervalle de temps chaud = $tc_{max}$ - $tc_{min}$

Avec :

- $tc_{min}$ : premier instant correspondant à une température ($T_{max}$ - $e_c$)

- $tc_{max}$ : deuxième instant correspondant à une température ($T_{max}$ - $e_c$)

- $tf_{min}$ : premier instant correspondant à une température ($T_{min}$ + $e_c$)

- $tf_{max}$ : deuxième instant correspondant à une température ($T_{min}$ + $e_c$) et :

- $e_c$, et : paramètres réglables correspondant à des écarts de température permettant d'englober la valeur maximale et la valeur minimale dans un intervalle de temps donné ;

De manière non limitative, on pourra définir que (Tmax - $e_c$) correspond à une température maximale de fonctionnement des appareils et que (Tmin + $e_f$) correspond à une température minimale de fonctionnement des appareils.

Pendant l'intervalle de temps chaud calculé, l'unité de commande et de traitement UC est amenée à appliquer le premier mode de fonctionnement MOD1.

Pendant l'intervalle de temps froid, l'unité de commande et de traitement UC est amenée à appliquer le deuxième mode de fonctionnement MOD2.

Dans toute autre situation, l'unité de commande et de traitement UC peut être amenée à appliquer le troisième mode de fonctionnement.

Dans une deuxième variante de réalisation, l'unité de commande et de traitement UC applique le mode de fonctionnement adapté en tenant compte de la température mesurée à l'intérieur de l'armoire électrique 1, donc à l'intérieur du volume V1. Dans ce cas, il s'agit d'un principe de régulation de température. Ainsi, l'unité de commande et de traitement UC peut fonctionner de la manière suivante :

- Si la température mesurée est supérieure à une valeur seuil prédéfinie, l'unité de commande et de traitement déclenche le premier mode de fonctionnement afin de transférer de l'air froid dans le volume V1 de l'armoire et donc refroidir les appareils électriques.

- Si la température mesurée est inférieure à une valeur seuil prédéfinie, l'unité de commande et de traitement déclenche le deuxième mode de fonctionnement afin de transférer de l'air chaud dans le volume V1 de l'armoire et donc de réchauffer l'intérieur de l'armoire électrique.

Dans cette dernière réalisation, le système peut comporter un capteur de température TEMP (représenté sur la figure 1) connecté sur un module d'entrée de l'unité de commande et de traitement UC et placé à l'intérieur de l'armoire électrique 1 afin de recueillir des données de mesure de température.

Dans une réalisation particulière, pendant un intervalle froid, l'unité de commande et de traitement US peut mettre en œuvre une régulation en comparant la température présente dans le volume V1 de l'armoire électrique avec la température de rosée.

Pour rappel, la température de rosée se calcule à partir de la relation suivante :

$$T°ros\acute{e}e = \frac{237,3}{\left[\dfrac{7,5}{Log_{10}(RH) + \left(\dfrac{7,5 \times T_{int}}{237,3 + T_{int}}\right) - 2} \right] - 1}$$

Avec RH qui correspond à l'humidité relative dans le volume V1 de l'armoire électrique et Tint qui correspond à la température à l'intérieur du volume V1 de l'armoire électrique.

Pendant l'intervalle froid, les moyens de calcul de l'unité de commande et de traitement comparent la température détermine la température de rosée pour chaque valeur mesurée de température dans le volume V1 de l'armoire électrique puis compare chaque valeur mesurée avec la température de rosée correspondante :

- Si la valeur mesurée de température est inférieure à la température de rosée calculée, l'unité de commande et de traitement UC applique le deuxième mode de fonctionnement MOD2 jusqu'à ce que la température mesurée devienne supérieure à la température de rosée correspondante, ceci afin d'éliminer le possible condensat.
- Si la valeur mesurée de température est supérieure à la température de rosée calculée, il n'y a pas de risque de formation de condensat et donc l'unité de commande et de traitement UC ne force aucun mode de fonctionnement, c'est-à-dire que aucun transfert d'air n'est commandé entre les volumes.

Dans cette réalisation, le système peut également intégrer le capteur de température TEMP connecté sur un module d'entrée de l'unité de commande et de traitement UC et placé à l'intérieur de l'armoire électrique 1 afin de recueillir des données de mesure de température. Pour déterminer la température de rosée, le système peut comporter un capteur d'humidité connecté sur un autre module d'entrée de l'unité de commande et de traitement UC afin de recueillir les données de mesure d'humidité à l'intérieur de l'armoire électrique.

Selon différents aspects particuliers, comme déjà évoqué ci-dessus, le réservoir 21 peut être réalisé dans un matériau non élastique (ou non extensible) ou dans un matériau extensible. Dans ce dernier cas, la pression exercée par les parois du réservoir 21 permet de libérer naturellement l'air présent dans le réservoir lors du deuxième mode de fonctionnement. Dans ce mode de fonctionnement, le seul ventilateur VENT employé entre le volume V1 et le volume V2 peut même être arrêté.

La solution de l'invention présente ainsi de nombreux avantages, parmi lesquels :

- Elle est simple à mettre en œuvre et est adaptable aisément sur une armoire électrique existante ;

- Elle n'utilise que des solutions classiques de ventilation pour fonctionner ;

- Elle permet de s'adapter facilement aux conditions de température externes ;

## Revendications

**1.** Système (2) de gestion de la température, adaptable sur une enveloppe électrique, ladite enveloppe électrique délimitant un premier volume (V1) fermé par rapport à l'extérieur, ledit système étant **caractérisé en ce qu'**il comporte :

    - Une première enceinte (20) délimitant un deuxième volume (V2) fermé et un réservoir (21) logé dans ladite première enceinte (20) et délimitant un troisième volume (V3) fermé à l'intérieur de ladite première enceinte, distinct du deuxième volume (V2),
    - Des premiers moyens de transfert d'air (MT1) agencés entre une première entrée/sortie d'air (I1) connectée au deuxième volume (V2) et une deuxième entrée/sortie d'air (I2) destinée à être connectée au premier volume (V1),
    - Des deuxièmes moyens de transfert d'air (MT2) agencés entre une troisième entrée/sortie d'air (I3) connectée au troisième volume (V3) et une quatrième entrée/sortie d'air (I4) destinée à être connectée au premier volume (V1),
- Une unité de commande et de traitement (UC) comprenant une première sortie de commande connectée auxdits premiers moyens de transfert d'air, une deuxième sortie de commande connectée auxdits deuxièmes moyens de transfert d'air et des moyens de détermination d'un mode de fonctionnement dudit système, ledit mode de fonctionnement étant choisi parmi au moins :

- Un premier mode de fonctionnement (MOD1) dans lequel l'unité de commande et de traitement (UC) commande les premiers moyens de transfert d'air pour générer un premier flux d'air du deuxième volume (V2) vers ledit premier volume (V1) et les deuxièmes moyens de transfert d'air pour générer un deuxième flux d'air du premier volume (V1) vers ledit troisième volume (V3),
- Un deuxième mode de fonctionnement (MOD2) dans lequel l'unité de commande et de traitement commande les premiers moyens de transfert d'air pour générer un premier flux d'air du premier volume (V1) vers ledit deuxième volume (V2) et les deuxièmes moyens de transfert d'air pour générer un deuxième flux d'air dudit troisième volume (V3) vers ledit premier volume (V1),
- le système (2) de gestion de la température présentant la particularité de pouvoir stocker de l'air chaud lors des périodes chaudes pour le restituer lors des périodes plus froides et de pouvoir stocker de l'air froid lors des périodes froides pour le restituer lors des périodes plus chaudes,
- dans le premier mode de fonctionnement, le premier transfert d'air du volume V1 vers le volume V3 étant un transfert d'air dit chaud, tandis que le deuxième transfert d'air du volume V2 vers le volume V1 est un transfert d'air dit froid,
- dans le deuxième mode de fonctionnement, le premier transfert d'air du volume V1 vers le volume V2 est un transfert d'air dit froid, tandis que le deuxième transfert d'air du volume V3 vers le volume V1 est un transfert d'air dit chaud ; et
- le réservoir (21) étant réalisé dans un matériau souple.

2. Système selon la revendication 1, **caractérisé en ce qu'**il comporte un troisième mode de fonctionnement (MOD3) dans lequel l'unité de commande et de traitement (UC) commande les premiers moyens de transfert d'air et les deuxièmes moyens de transfert d'air pour bloquer tout flux d'air respectivement entre le premier volume et le deuxième volume et entre le premier volume et le troisième volume.

3. Système selon la revendication 1 ou 2, **caractérisé en ce qu'**il comporte des moyens de détermination d'une première période d'activation des premiers moyens de transfert d'air (MT1) et des deuxièmes moyens de transfert d'air (MT2) et d'une deuxième période d'activation des premiers moyens de transfert d'air (MT1) et des deuxièmes moyens de transfert d'air (MT2).

4. Système selon la revendication 3, **caractérisé en ce que** la première période d'activation est définie par un premier intervalle de temps dénommé Dtc et défini par la relation suivante :

$$Dtc = tc_{max} - tc_{min}$$

Dans laquelle :

- $tc_{min}$ correspond à un premier instant correspondant à la température ($T_{max} - e_c$),
- $tCmax$ correspond à un deuxième instant correspondant à la température ($T_{max} - e_c$),
- Tmax correspond à une valeur maximale de température subie par le système sur une période donnée et $e_c$ correspond à un premier écart de température.

5. Système selon la revendication 3 ou 4, **caractérisé en ce que** la deuxième période d'activation est définie par un deuxième intervalle de temps dénommé Dtf et défini par la relation suivante :

$$Dtf = tf_{max} - tf_{min}$$

Dans laquelle :

- $tf_{min}$ correspond à un premier instant correspondant à une température ($T_{min} + e_f$),
- $tf_{max}$ correspond à un deuxième instant correspondant à la température ($T_{min} + e_f$),

- Tmin correspond à une valeur minimale de température subie par le système sur ladite période donnée et $e_f$ correspond à un deuxième écart de température.

6. Système selon la revendication 4 ou 5, **caractérisé en ce qu'**il comporte un capteur de température (TEMP) configurée pour fournir la valeur minimale de température et la valeur maximale de température.

7. Système selon l'une des revendications 4 à 6, **caractérisé en ce qu'**il comporte des moyens de connexion à un serveur de données météorologiques et des moyens d'interrogation dudit serveur pour obtenir ladite valeur minimale de température et ladite valeur maximale de température et une courbe d'évolution de la température.

8. Système selon la revendication 1 ou 2, **caractérisé en ce qu'**il comporte un capteur de température (TEMP) destiné aàêtre placé dans le premier volume et **en ce que** l'unité de commande et de traitement (UC) comporte une entrée reliée audit capteur de température et **en ce que** lesdits moyens de détermination du mode de fonctionnement sont configurés pour se baser sur des données de mesure de température fournies par ledit capteur.

9. Système selon la revendication 8, **caractérisé en ce que** lesdits moyens de détermination du mode de fonctionnement comportent des moyens de comparaison de chaque donnée de température fournie par ledit capteur de température (TEMP) avec au moins une valeur seuil.

10. Système selon la revendication 8 ou 9, **caractérisé en ce que** lesdits moyens de détermination du mode de fonctionnement comportent des moyens de calcul de la température de rosée et **en ce qu'**il comporte des moyens de comparaison de chaque donnée de température fournie par ledit capteur de température (TEMP) avec ladite température de rosée.

11. Système selon l'une des revendications 1 à 10, **caractérisé en ce que** les premiers moyens de transfert d'air (MT1) comportent un premier ventilateur (VENT1) commandé par l'unité de commande et de traitement.

12. Système selon l'une des revendications 1 à 11, **caractérisé en ce que** les premiers moyens de transfert d'air (MT1) comportent des moyens d'obturation de la première entrée/sortie d'air et/ou de la deuxième entrée/sortie d'air, commandés par l'unité de commande et de traitement.

13. Système selon l'une des revendications 1 à 12, **caractérisé en ce que** les deuxièmes moyens de transfert d'air (MT2) comportent un deuxième ventilateur (VENT2) commandé par l'unité de commande et de traitement.

14. Système selon l'une des revendications 1 à 13, **caractérisé en ce que** les deuxièmes moyens de transfert d'air (MT2) comportent des moyens d'obturation de la troisième entrée/sortie d'air et/ou de la quatrième entrée/sortie d'air, commandés par l'unité de commande et de traitement.

15. Système selon l'une des revendications 1 à 10, **caractérisé en ce que** les premiers moyens de transfert d'air (MT1) et les deuxièmes moyens de transfert d'air (MT2) comportent une platine (23) rotative autour d'un axe, ladite platine portant un unique ventilateur (VENT) et une ouverture (O) diamétralement opposés et étant commandé par l'unité de commande et de traitement (UC) pour tourner autour de son axe entre au moins deux positions, une première position angulaire dans laquelle son ventilateur (VENT) est positionné entre la première entrée/sortie d'air (I1) et la deuxième entrée sortie d'air (I2) et son ouverture (O) est positionnée entre la troisième entrée/sortie d'air (I3) et la quatrième entrée sortie d'air (I4) et une deuxième position angulaire dans laquelle son ventilateur (VENT) est positionné entre la troisième entrée/sortie d'air (I3) et la quatrième entrée/sortie d'air (I4) et son ouverture (O) est positionnée entre la première entrée/sortie d'air (I1) et la deuxième entrée/sortie d'air (I2).

16. Système selon la revendication 15, **caractérisé en ce que** la première position angulaire et la deuxième position angulaire sont obtenues par une rotation de la platine (23) de 180°.

17. Système selon la revendication 15 ou 16, **caractérisé en ce que** la platine (23) est configurée pour prendre au moins une troisième position angulaire décalée de 90° par rapport à la première position angulaire, ladite troisième position angulaire correspondant à un mode de fonctionne ment dans lequel la platine (23) s'interpose entre la première entrée/sortie d'air (I1) et la deuxième entrée/sortie d'air (I2) pour bloquer leur liaison et la platine (23) s'interpose entre la troisième entrée/sortie d'air (I3) et la quatrième entrée/sortie d'air (I4) pour bloquer leur liaison.

18. Système selon l'une des revendications 1 à 17, **caractérisé en ce que** le réservoir (21) est réalisé dans un matériau extensible.

**19.** Installation électrique comportant une enveloppe électrique qui comprend une paroi inférieure (10), une paroi supérieure (I1) et au moins une paroi latérale (12), de manière à délimiter un premier volume (V1) fermé, **caractérisé en ce que** l'installation comporte un système (2) tel que défini dans l'une des revendications 1 à 18 qui est installé sur l'une de ses parois, la deuxième entrée/sortie d'air (I2) et la quatrième entrée/sortie d'air (I4) du système étant connectés audit premier volume (V1).

**20.** Procédé de gestion de la température dans une installation électrique telle que définie dans la revendication 19, **caractérisé en ce qu'**il comporte les étapes suivantes :

- Sélection d'un mode de fonctionnement du système,
- Application dudit mode de fonctionnement sélectionné par commande des premiers moyens de transfert d'air (MT1) et des deuxièmes moyens de transfert d'air (MT2).

**Patentansprüche**

**1.** System (2) zur Temperatursteuerung, das an ein elektrisches Gehäuse anpassbar ist, wobei das elektrische Gehäuse ein erstes Volumen (V1) begrenzt, das gegenüber dem Äußeren geschlossen ist, wobei das System **dadurch gekennzeichnet ist, dass** es Folgendes aufweist:

- Eine erste Umhausung (20), die ein zweites geschlossenes Volumen (V2) und einen Vorratsbehälter (21) begrenzt, der in der ersten Umhausung (20) aufgenommen ist und ein drittes geschlossenes Volumen (V3) innerhalb der ersten Umhausung begrenzt, das vom zweiten Volumen (V2) gesondert ist,
- Erste Luftübertragungsmittel (MT1), die zwischen einem ersten Luftein-/auslass (I1), der an das zweite Volumen (V2) angeschlossen ist, und einem zweiten Luftein-/auslass (I2), der dazu bestimmt ist, an das erste Volumen (V1) angeschlossen zu sein, angeordnet sind,
- Zweite Luftübertragungsmittel (MT2), die zwischen einem dritten Luftein-/auslass (I3), der an das dritte Volumen (V3) angeschlossen ist, und einem vierten Luftein-/auslass (I4), der dazu bestimmt ist, an das erste Volumen (V1) angeschlossen zu sein, angeordnet sind,
- Eine Steuer- und Verarbeitungseinheit (UC) umfassend einen ersten Steuerungsausgang, der an die ersten Luftübertragungsmittel angeschlossen ist, einen zweiten Steuerungsausgang, der an die zweiten Luftübertragungsmittel angeschlossen ist, und Mittel zur Bestimmung eines Betriebsmodus des Systems, wobei der Betriebsmodus aus wenigstens Folgendem gewählt ist:
- Einem ersten Betriebsmodus (MOD1), in dem die Steuer- und Verarbeitungseinheit (UC) die ersten Luftübertragungsmittel steuert, um einen ersten Luftstrom vom zweiten Volumen (V2) zum ersten Volumen (V1) zu erzeugen, und die zweiten Luftübertragungsmittel steuert, um einen zweiten Luftstrom vom ersten Volumen (V1) zum dritten Volumen (V3) zu erzeugen,
- Einem zweiten Betriebsmodus (MOD2), in dem die Steuer- und Verarbeitungseinheit (UC) die ersten Luftübertragungsmittel steuert, um einen ersten Luftstrom vom ersten Volumen (V1) zum zweiten Volumen (V2) zu erzeugen, und die zweiten Luftübertragungsmittel steuert, um einen zweiten Luftstrom vom dritten Volumen (V3) zum ersten Volumen (V1) zu erzeugen,
- wobei das System (2) zur Temperatursteuerung die Besonderheit aufweist, bei den warmen Perioden Warmluft speichern zu können, um sie bei den kälteren Perioden wieder abzugeben, und bei den kalten Perioden Kaltluft speichern zu können, um sie bei den wärmeren Perioden wieder abzugeben,
- wobei im ersten Betriebsmodus die erste Luftübertragung vom Volumen V1 zum Volumen V3 eine Warmluftübertragung ist, während die zweite Luftübertragung vom Volumen V2 zum Volumen V1 eine Kaltluftübertragung ist,
- im zweiten Betriebsmodus die erste Luftübertragung vom Volumen V1 zum Volumen V2 eine Kaltluftübertragung ist, während die zweite Luftübertragung vom Volumen V3 zum Volumen V1 eine Warmluftübertragung ist; und
- wobei der Vorratsbehälter (21) aus einem nachgiebigen Material hergestellt ist.

**2.** System nach Anspruch 1, **dadurch gekennzeichnet, dass** es einen dritten Betriebsmodus (MOD3) aufweist, in dem die Steuer- und Verarbeitungseinheit (UC) die ersten Luftübertragungsmittel und die zweiten Luftübertragungsmittel steuert, um jeglichen Luftstrom zwischen dem ersten Volumen und dem zweiten Volumen und zwischen dem ersten Volumen und dem dritten Volumen zu blockieren.

**3.** System nach Anspruch 1 oder 2, **dadurch gekennzeichnet, dass** es Mittel zur Bestimmung einer ersten Aktivierungsperiode der ersten Luftübertragungsmittel (MT1) und der zweiten Luftübertragungsmittel (MT2) und einer zweiten Aktivierungsperiode der ersten Luftübertragungsmittel (MT1) und der zweiten Luftübertragungsmittel (MT2) aufweist.

**4.** System nach Anspruch 3, **dadurch gekennzeichnet, dass** die erste Aktivierungsperiode von einem ersten Zeitintervall definiert ist, das Dtc genannt wird und durch die folgende Beziehung definiert ist:

$$Dtc = tc_{max} - tc_{min}$$

Wobei:

- $tc_{min}$ einem ersten Zeitpunkt entspricht, der der Temperatur ($T_{max} - e_c$) entspricht,
- $tc_{max}$ einem zweiten Zeitpunkt entspricht, der der Temperatur ($T_{max} - e_c$) entspricht,
- Tmax einem Temperaturmaximalwert entspricht, dem das System über eine bestimmte Zeitspanne unterliegt, und $e_c$ einem ersten Temperaturunterschied entspricht.

**5.** System nach Anspruch 3 oder 4, **dadurch gekennzeichnet, dass** die zweite Aktivierungsperiode von einem zweiten Zeitintervall definiert ist, das Dtf genannt wird und durch die folgende Beziehung definiert ist:

$$Dtf = tf_{max} - tf_{min}$$

Wobei:

- $tf_{min}$ einem ersten Zeitpunkt entspricht, der einer Temperatur ($T_{min} + e_f$) entspricht,
- $tf_{max}$ einem zweiten Zeitpunkt entspricht, der der Temperatur ($T_{min} + e_f$) entspricht,
- Tmin einem Temperaturminimalwert entspricht, dem das System über die bestimmte Zeitspanne unterliegt, und $e_f$ einem zweiten Temperaturunterschied entspricht.

**6.** System nach Anspruch 4 oder 5, **dadurch gekennzeichnet, dass** es einen Temperatursensor (TEMP) aufweist, der dazu ausgebildet ist, den Temperaturminimalwert und den Temperaturmaximalwert bereitzustellen.

**7.** System nach einem der Ansprüche 4 bis 6, **dadurch gekennzeichnet, dass** es Mittel zur Verbindung mit einem Server für meteorologische Daten und Mittel zur Abfrage des Servers aufweist, um den Temperaturminimalwert und den Temperaturmaximalwert und eine Entwicklungskurve der Temperatur zu erhalten.

**8.** System nach Anspruch 1 oder 2, **dadurch gekennzeichnet, dass** es einen Temperatursensor (TEMP) aufweist, der dazu bestimmt ist, im ersten Volumen platziert zu sein, und dadurch, dass die Steuer- und Verarbeitungseinheit (UC) einen Eingang aufweist, der mit dem Temperatursensor verbunden ist, und dadurch, dass die Mittel zur Bestimmung des Betriebsmodus dazu ausgebildet sind, sich auf Temperaturmessdaten zu stützen, die vom Sensor bereitgestellt werden.

**9.** System nach Anspruch 8, **dadurch gekennzeichnet, dass** die Mittel zur Bestimmung des Betriebsmodus Mittel zum Vergleichen jedes Temperaturdatenelements, das vom Temperatursensor (TEMP) bereitgestellt wird, mit wenigstens einem Schwellenwert aufweisen.

**10.** System nach Anspruch 8 oder 9, **dadurch gekennzeichnet, dass** die Mittel zur Bestimmung des Betriebsmodus Mittel zur Berechnung der Tautemperatur aufweisen, und dadurch, dass es Mittel zum Vergleichen jedes Temperaturdatenelements, das vom Temperatursensor (TEMP) bereitgestellt wird, mit der Tautemperatur aufweist.

**11.** System nach einem der Ansprüche 1 bis 10, **dadurch gekennzeichnet, dass** die ersten Luftübertragungsmittel (MT1) einen ersten Ventilator (VENT1) aufweisen, der von der Steuer- und Verarbeitungseinheit gesteuert wird.

**12.** System nach einem der Ansprüche 1 bis 11, **dadurch gekennzeichnet, dass** die ersten Luftübertragungsmittel (MT1) Mittel zum Verschließen des ersten Luftein-/auslasses und/oder des zweiten Luftein-/auslasses aufweisen, die von der Steuer- und Verarbeitungseinheit gesteuert werden.

**13.** System nach einem der Ansprüche 1 bis 12, **dadurch gekennzeichnet, dass** die zweiten Luftübertragungsmittel (MT2) einen zweiten Ventilator (VENT2) aufweisen, der von der Steuer- und Verarbeitungseinheit gesteuert wird.

**14.** System nach einem der Ansprüche 1 bis 13, **dadurch gekennzeichnet, dass** die zweiten Luftübertragungsmittel (MT2) Mittel zum Verschließen des dritten Luftein-/auslasses und/oder des vierten Luftein-/auslasses aufweisen, die von der Steuer- und Verarbeitungseinheit gesteuert werden.

**15.** System nach einem der Ansprüche 1 bis 10, **dadurch gekennzeichnet, dass** die ersten Luftübertragungsmittel (MT1) und die zweiten Luftübertragungsmittel (MT2) eine um eine Achse drehbare Platte (23) aufweisen, wobei die Platte einen einzelnen Ventilator (VENT) und eine Öffnung (O) trägt, die diametral entgegengesetzt sind, und von der Steuer- und Verarbeitungseinheit (UC) gesteuert wird, um sich zwischen wenigstens zwei Positionen um ihre Achse zu drehen, einer ersten Winkelposition, in der ihr Ventilator (VENT) zwischen dem ersten Luftein-/auslass (I1) und dem zweiten Luftauslass (I2) positioniert ist und ihre Öffnung (O) zwischen dem dritten Luftein-/auslass (I3) und dem vierten Luftein-/auslass (I4) positioniert ist, und einer zweiten Winkelposition, in der ihr Ventilator (VENT) zwischen dem dritten Luftein-/auslass (I3) und dem vierten Luftauslass (I4) positioniert ist und ihre Öffnung (O) zwischen dem ersten Luftein-/auslass (I1) und dem zweiten Luftein-/auslass (I2) positioniert ist.

**16.** System nach Anspruch 15, **dadurch gekennzeichnet, dass** die erste Winkelposition und die zweite Winkelposition durch eine Drehung der Platte (23) um 180° erreicht werden.

**17.** System nach Anspruch 15 oder 16, **dadurch gekennzeichnet, dass** die Platte (23) dazu ausgebildet ist, wenigstens eine dritte Winkelposition einzunehmen, die im Verhältnis zur ersten Winkelposition um 90° versetzt ist, wobei die dritte Winkelposition einem Betriebsmodus entspricht, in dem sich die Platte (23) zwischen den ersten Luftein-/auslass (I1) und den zweiten Luftein-/auslass (I2) einfügt, um deren Verbindung zu blockieren, und sich die Platte (23) zwischen den dritten Luftein-/auslass (I3) und den vierten Luftein-/auslass (I4) einfügt, um deren Verbindung zu blockieren.

**18.** System nach einem der Ansprüche 1 bis 17, **dadurch gekennzeichnet, dass** der Vorratsbehälter (21) aus einem dehnbaren Material hergestellt ist.

**19.** Elektrischen Anlage aufweisend ein elektrisches Gehäuse, das eine untere Wand (10), eine obere Wand (11) und wenigstens eine Seitenwand (12) umfasst, um ein erstes geschlossenes Volumen (V1) zu begrenzen, **dadurch gekennzeichnet, dass** die Anlage ein System (2) nach einem der Ansprüche 1 bis 18 aufweist, das an einem ihrer Wände installiert ist, wobei der zweite Luftein-/auslass (I2) und der vierte Luftein-/auslass (I4) des Systems mit dem ersten Volumen (V1) verbunden sind.

**20.** Verfahren zur Temperatursteuerung in einer elektrischen Anlage nach Anspruch 19, **dadurch gekennzeichnet, dass** es die folgenden Schritte aufweist:

- Auswählen eines Betriebsmodus des Systems,
- Anwenden des ausgewählten Betriebsmodus durch Steuerung der ersten Luftübertragungsmittel (MT1) und der zweiten Luftübertragungsmittel (MT2).

**Claims**

**1.** Temperature management system (2), that can be adapted to an electrical enclosure, said electrical enclosure delimiting a first volume (V1) that is closed with respect to the outside, said system being **characterized in that** it comprises:

- a first chamber (20) delimiting a second closed volume (V2) and a tank (21) housed in said first chamber (20) and delimiting a third closed volume (V3) inside said first chamber, distinct from the second volume (V2),
- first air transfer means (MT1) arranged between a first air inlet/outlet (11) connected to the second volume (V2) and a second air inlet/outlet (12) intended to be connected to the first volume (V1),
- second air transfer means (MT2) arranged between a third air inlet/outlet (13) connected to the third volume (V3) and a fourth air inlet/outlet (14) intended to be connected to the first volume (V1),
- a control and processing unit (UC) comprising a first command output connected to said first air transfer means, a second command output connected to said second air transfer means and means for determining a mode of operation of said system, said mode of operation being chosen from among at least:

- a first mode of operation (MOD1) in which the control and processing unit (UC) controls the first air transfer means for generating a first air flow from the second volume (V2) to said first volume (V1) and the second air transfer means for generating a second air flow from the first volume (V1) to said third volume (V3),
- a second mode of operation (MOD2) in which the control and processing unit controls the first air transfer means for generating a first air flow from the first volume (V1) to said second volume (V2) and the second air transfer means for generating a second air flow from said third volume (V3) to said first volume (V1),
- the temperature management system (2) having the particular feature of being able to store hot air during hot periods to restore it in colder periods and of being able to store cold air during cold periods to restore it in hotter periods,
- in the first mode of operation, the first air transfer from the volume V1 to the volume V3 being a so-called hot air transfer, whereas the second air transfer from the volume V2 to the volume V1 is a so-called cold air transfer,
- in the second mode of operation, the first air transfer from the volume V1 to the volume V2 is a so-called cold air transfer, whereas the second air transfer from the volume V3 to the volume V1 is a so-called hot air transfer; and
- the tank (21) being made from a flexible material.

2. System according to Claim 1, **characterized in that** it comprises a third mode of operation (MOD3) in which the control and processing unit (UC) controls the first air transfer means and the second air transfer means to block any air flow respectively between the first volume and the second volume and between the first volume and the third volume.

3. System according to Claim 1 or 2, **characterized in that** it comprises means for determining a first period of activation of the first air transfer means (MT1) and of the second air transfer means (MT2) and a second period of activation of the first air transfer means (MT1) and of the second air transfer means (MT2).

4. System according to Claim 3, **characterized in that** the first activation period is defined by a first time interval named Dtc and defined by the following relationship:

$$Dtc = tc_{max} - tc_{min}$$

in which:

- $tc_{min}$ corresponds to a first instant corresponding to the temperature ($T_{max}$ - ec),
- $tc_{max}$ corresponds to a second instant corresponding to the temperature ($T_{max}$ - $e_c$),
- Tmax corresponds to a maximum temperature value sustained by the system over a given period and $e_c$ corresponds to a first temperature difference.

5. System according to Claim 3 or 4, **characterized in that** the second activation period is defined by a second time interval named Dtf and defined by the following relationship:

$$Dtf = tf_{max} - tf_{min}$$

in which:

- $tf_{min}$ corresponds to a first instant corresponding to a temperature ($T_{min}$ + $e_f$),
- $tf_{max}$ corresponds to a second instant corresponding to the temperature ($T_{min}$ + $e_f$),
- Tmin corresponds to a minimum temperature value sustained by the system over said given period and $e_f$ corresponds to a second temperature difference.

6. System according to Claim 4 or 5, **characterized in that** it comprises a temperature sensor (TEMP) configured to supply the minimum temperature value and the maximum temperature value.

7. System according to one of Claims 4 to 6, **characterized in that** it comprises means for connecting to a meteorological data server and means for interrogating said server to obtain said minimum temperature value and said maximum temperature value and a temperature trend curve.

8. System according to Claim 1 or 2, **characterized in that** it comprises a temperature sensor (TEMP) intended to be placed in the first volume and **in that** the control and processing unit (UC) comprises an input linked to said temperature sensor and **in that** said means for determining the mode of operation are configured to be based on temperature measurement data supplied by said sensor.

9. System according to Claim 8, **characterized in that** said means for determining the mode of operation comprise means for comparing each temperature datum supplied by said temperature sensor (TEMP) with at least one threshold value.

10. System according to Claim 8 or 9, **characterized in that** said means for determining the mode of operation comprise means for calculating the dew point temperature and **in that** it comprises means for comparing each temperature datum supplied by said temperature sensor (TEMP) with said dew point temperature.

11. System according to one of Claims 1 to 10, **characterized in that** the first air transfer means (MT1) comprise a first fan (VENT1) controlled by the control and processing unit.

12. System according to one of Claims 1 to 11, **characterized in that** the first air transfer means (MT1) comprise means for blocking the first air inlet/outlet and/or the second air inlet/outlet controlled by the control and processing unit.

13. System according to one of Claims 1 to 12, **characterized in that** the second air transfer means (MT2) comprise a second fan (VENT2) controlled by the control and processing unit.

14. System according to one of Claims 1 to 13, **characterized in that** the second air transfer means (MT2) comprise means for blocking the third air inlet/outlet and/or the fourth air inlet/outlet, controlled by the control and processing unit.

15. System according to one of Claims 1 to 10, **characterized in that** the first air transfer means (MT1) and the second air transfer means (MT2) comprise a plate (23) that rotates about an axis, said plate bearing a single fan (VENT) and an aperture (O) that are diametrically opposite and being controlled by the control and processing unit (UC) to revolve about its axis between at least two positions, a first angular position in which its fan (VENT) is positioned between the first air inlet/outlet (11) and the second air inlet/outlet (12) and its aperture (O) is positioned between the third air inlet/outlet (13) and the fourth air inlet/outlet (14) and a second angular position in which its fan (VENT) is positioned between the third air inlet/outlet (13) and the fourth air inlet/outlet (14) and its aperture (O) is positioned between the first air inlet/outlet (11) and the second air inlet/outlet (12).

16. System according to Claim 15, **characterized in that** the first angular position and the second angular position are obtained by a rotation of the plate (23) of 180°.

17. System according to Claim 15 or 16, **characterized in that** the plate (23) is configured to take at least one third angular position that is offset by 90° with respect to the first angular position, said third angular position corresponding to a mode of operation in which the plate (23) is interposed between the first air inlet/outlet (11) and the second air inlet/outlet (12) to block the linking thereof and the plate (23) is interposed between the third air inlet/outlet (13) and the fourth air inlet/outlet (14) to block the linking thereof.

18. System according to one of Claims 1 to 17, **characterized in that** the tank (21) is made from an extendable material.

19. Electrical installation comprising an electrical enclosure which comprises a bottom wall (10), a top wall (11) and at least one side wall (12), so as to delimit a first closed volume (V1), **characterized in that** the installation comprises a system (2) as defined in one of Claims 1 to 18 which is installed on one of its walls, the second air inlet/outlet (12) and the fourth air inlet/outlet (14) of the system being connected to said first volume (V1).

20. Method for managing the temperature in an electrical installation as defined in Claim 19, **characterized in that** it comprises the following steps:

   - selection of a mode of operation of the system,

- application of said selected mode of operation by control of the first air transfer means (MT1) and of the second air transfer means (MT2).

**Fig. 1**

**Fig. 2**

*Fig. 3*

**Fig. 4A**

MOD1

**Fig. 4B**

MOD1

## Fig. 5A

MOD2

V3

21

2

20

V2

UC

11

TEMP

13

22

12

1

14

10

## Fig. 5B

MOD2

V3

V2

I3

VENT2

I1

V1

V1

I4

I2

**Fig. 6A**

MOD3

2

21

V3

20

V2

UC

11

TEMP

22

13

12

1

14

10

**Fig. 6B**

MOD3

V3

VENT1

V2

I3

I1

V1

V1

I4

I2

Fig. 7A

0°

(X)

O

23

I3/I4

I1/I2

VENT

Fig. 7B

90°

(X)

23

O

VENT

Fig. 7C

180°

(X)
VENT

23

I3/I4

I1/I2

O

Fig. 7D

270°

(X)

23

I1/I2

VENT

O

Fig. 7E

(X)

23

O

I3/I4

I1/I2

VENT

**Fig. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2789220 A
- EP 3093936 A